# EUROPEAN PATENT SPECIFICATION

(11) **EP 3 176 802 B1**
(45) Date of publication and mention of the grant of the patent: **11.04.2018**
(21) Application number: 14761671.8
(22) Date of filing: 29.07.2014
(51) Int. Cl.: H01H 47/00, H02J 3/38, G01R 31/327, G01R 31/40, G01R 31/04, H02M 1/084, H02M 7/44

(54) **SYSTEM AND METHOD FOR VERIFYING CIRCUIT-BREAKER MEANS OF AN AC/DC CONVERTER**
SYSTEM UND VERFAHREN ZUR VERIFIZIERUNG EINES LEISTUNGSSCHALTERS EINES WECHSELSTROM-GLEICHSTROMWANDLERS
SYSTÈME ET PROCÉDÉ DE VÉRIFICATION DE MOYENS DE DÉCONNEXION D'UN CONVERTISSEUR CC/CA

(43) Date of publication of application: 07.06.2017
(73) Proprietor: Ingeteam Power Technology, S.A., 48170 Zamudio (Bizkaia) (ES)
(72) Inventor: MUGUERZA OLCOZ, Luis, 31621 Sarriguren (Navarra) (ES); BALDA BELZUNEGUI, Julian, 31621 Sarriguren (Navarra) (ES); BORREGA AYALA, Mikel, 31621 Sarriguren (Navarra) (ES); GONZALEZ SENOSIAIN, Roberto, 31621 Sarriguren (Navarra) (ES)
(74) Representative: Igartua, Ismael
(86) International application number: PCT/ES2014/070612
(87) International publication number: WO 2016/016479

(56) References cited:
- EP-A2- 2 608 375
- CN-U- 202 522 678
- US-A1- 2010 226 160
- US-A1- 2011 298 470

## Description

### TECHNICAL FIELD

The main field of application of the present invention is in the industry dedicated to designing electronic devices and, more particularly, electronic devices intended for being used in the sector of power systems for photovoltaic solar energy conversion. The invention may also be applicable in other fields such as wind power generation, power generation by means of electrochemical cells or other devices that provide continuous power.

### PRIOR ART

Grid-connected photovoltaic installations are formed by an array of photovoltaic panels (photovoltaic generator) and an electronic direct current-alternating current (DC/AC) converter, also known as an inverter, conditioning the continuous power produced by the panels, converting it into alternative energy and injecting it to the power grid. This photovoltaic inverter is connected to and disconnected from the distribution grid through disconnecting means, such as relays or contactors, for example. These means must uncouple from the inverter of the grid in response to an alarm situation or when the inverter is OFF, therefore assuring the insulation between the power grid and the photovoltaic installation.

Certain photovoltaic inverter electrical safety standards, such as IEC 62109 (Safety of power converters for use in photovoltaic power systems) require installing these disconnecting means in the inverters. In inverters without transformer, the standard requires the use of two disconnecting means arranged in series by phase. They also require verifying the correct opening and closing of said means. This verification must be performed at least every time the inverter makes a connection with the power grid.

Personal safety may be affected if malfunction of the disconnecting means occurs, for example, the contacts of a disconnecting system are welded together and do not establish disconnection from the power grid. For this reason, the inverter must be capable of detecting the correct operation of these disconnecting means.

There are different methods for detecting defect in a disconnecting system. In an inverter with double disconnecting system, a typical method consists of taking six voltage measurements, three of them on the grid side and three of them between the different disconnecting means of one and the same phase (for each phase). An example of this system is disclosed in document US20100226160A1, according to the preamble of method claim 7, where, for each phase, on one hand, the voltage between the midpoint between two serially connected systems and a reference point of the inverter is measured, and on the other hand, the voltage between the neutral of the grid and the output of the system connected to the grid is measured. This document therefore discloses a method that requires using six voltage measurements, with their six corresponding voltage meters or detectors to verify for the correct operation of the disconnecting means. Each of these meters involves the inclusion of a signal processing hardware affecting the final cost of the inverter.

EP-A2-2608375 discloses a system for verifying the disconnection means of a three-phase DC/AC converter according to the preamble of claim 1.

### DISCLOSURE OF THE INVENTION

An object of the invention is to provide a verifying system for verifying the status of disconnecting means arranged between a three-phase DC/AC converter and a power grid, as described in the claims.

The verifying system of the invention is used for verifying the status of disconnecting means arranged between a three-phase DC/AC converter and a power grid, status of the disconnecting means being understood as whether or not said disconnecting means work correctly. Each phase comprises two disconnecting means arranged in series between the grid and the three-phase DC/AC converter. The system comprises a plurality of voltage detectors and a control unit which is communicated with the plurality of voltage detectors to receive the voltages measured by said detectors and which is configured to determine the status of the disconnecting means depending on said voltages.

The plurality of voltage detectors comprises a voltage detector associated with each phase for measuring the voltages between the midpoint of the disconnecting means corresponding to each phase and the neutral of the power grid, and an additional voltage detector for measuring the voltage between the neutral of the power grid and a reference point of the DC converter side.

Therefore, as a result of measuring the voltage at the midpoints of each phase and of measuring the voltage between the neutral of the power grid and the reference point of the converter, said measured voltages at the midpoints can be associated both with the power grid and the converter, which allows verifying all the disconnecting means (both those which are on the converter side and those which are on the power grid side), with a smaller number of detectors (four) than that used in the state of the art (six), with the advantages that it entails in terms of cost and simplicity in design, for example.

Another object of the invention is to provide a verifying method for verifying the status of disconnecting means arranged between a three-phase DC/AC converter and a power grid, as described in the claims.

The verifying method of the invention is used for verifying the status of disconnecting means arranged between a three-phase DC/AC converter and a power grid, status of the disconnecting means being understood as whether or not said disconnecting means work correctly. In the method, the phase voltage between the midpoint of the three phases and the neutral of the power grid is measured, the reference voltage between the neutral of the power grid and the reference point of the converter is measured, and the status of the disconnecting means is determined taking into account the measured voltages. At least the advantages described for the verifying system of the invention are obtained with the method of the invention.

These and other advantages and features of the invention will become evident in view of the drawings and the detailed description of the invention.

### DESCRIPTION OF THE DRAWINGS

Figure 1 schematically shows an embodiment of the verifying system of the invention.
Figure 2 shows a block diagram of a preferred embodiment of the method of the invention.
Figure 3 schematically shows the system of Figure 1 in which the external disconnecting means of one phase have a defect.
Figure 4 schematically shows the system of Figure 1 in which the internal disconnecting means of one phase have a defect.

### DETAILED DISCLOSURE OF THE INVENTION

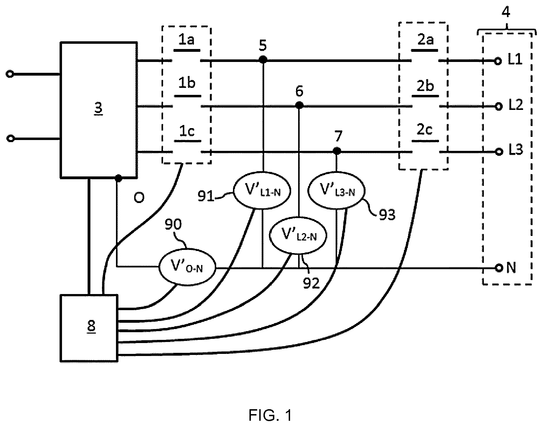

A first aspect of the invention relates to a verifying system for verifying disconnecting means 1a, 1b, 1c, 2a, 2b and 2c arranged between a three-phase DC/AC converter 3 and a power grid 4. In each phase L1, L2 and L3, there are arranged two disconnecting means 1a and 2a, 1b and 2b, and 1c and 2c connected in series through a corresponding midpoint 5, 6 and 7, as shown in Figure 1, for example. Hereinafter, those disconnecting means which are on the side of the three-phase DC/AC converter 3 (between the respective midpoints 5, 6 and 7 and the three-phase DC/AC converter 3) are called internal disconnecting means 1a, 1b and 1c, and those disconnecting means which are on the side of the power grid 4 (between the respective midpoints 5, 6 and 7 and the power grid 4) are called external disconnecting means 2a, 2b and 2c.

The system comprises a plurality of voltage detectors 90, 91, 92 and 93 and a control unit 8 which is communicated with the detectors 90, 91, 92 and 93 to receive the respective voltages V'_{O-N}, V'_{L1-N}, V'_{L2-N} and V'_{L3-N} measured by said plurality of detectors 90, 91, 92 and 93 and which is configured to determine the status of the disconnecting means 1a, 1b, 1c, 2a, 2b and 2c depending on said voltages V'_{O-N}, V'_{L1-N}, V'_{L2-N} and V'_{L3-N}. The plurality of voltage detectors 90, 91, 92 and 93 comprises a respective voltage detector 91, 92 and 93 associated with each phase L1, L2 and L3 between the midpoint 5, 6 and 7 corresponding to each phase L1, L2 and L3 and the neutral N of the power grid 4 for measuring the phase voltages V'_{L1-N}, V'_{L2-N} and V'_{L3-N}, and an additional voltage detector 90 between the neutral N of the power grid 4 and a reference point O of the DC side of the three-phase DC/AC converter 3 for measuring the reference voltage V'_{O-N}. Therefore, an efficient verification can be achieved with the system of the invention using a smaller number of voltage detectors (four) in comparison with the number used in the state of the art (six).

The control unit 8 is also communicated with the disconnecting means 1a, 1b, 1c, 2a, 2b and 2c to enable controlling the opening and closing of said disconnecting means 1a, 1b, 1c, 2a, 2b and 2c and is furthermore configured for combining in a specific manner the measured voltages V'_{L1-N}, V'_{L2-N}, V'_{L3-N} and V'_{O-N} and the control of the disconnecting means 1a, 1b, 1c, 2a, 2b and 2c for the purpose of verifying whether or not said disconnecting means 1a, 1b, 1c, 2a, 2b and 2c work correctly depending on said combination.

The three-phase DC/AC converter 3 comprises a plurality of semiconductor-type switches (not depicted in the drawings), the control unit 8 also being configured for controlling the opening and closing of said switches of the three-phase DC/AC converter 3. When verifying the status of the disconnecting means 1a, 1b, 1c, 2a, 2b and 2c, said control is linked to the voltages V'_{L1-N}, V'_{L2-N}, V'_{L3-N} and V'_{O-N} measured by the plurality of respective voltage detectors 91, 92, 93 and 90 and to the control over the opening and closing of the disconnecting means 1a, 1b, 1c, 2a, 2b and 2c in a controlled manner.

The internal disconnecting means 1a, 1b, 1c can be controlled by a single signal from the control unit 8 (all disconnecting means being controlled by the same signal) or by three independent signals from the control unit 8 (each disconnecting means being controlled by one signal). Similarly, the external disconnecting means 2a, 2b and 2c can be controlled by a single signal from the control unit 8 (all disconnecting means being controlled by the same signal) or by three independent signals from the control unit 8 (each disconnecting means being controlled by one signal).

The reference point O can be the negative of the DC side of the three-phase DC/AC converter 3, the positive of said DC side or an intermediate point between said positive and said negative, whereby allows obtaining a known voltage per phase L1, L2 and L3 on the side of the three-phase DC/AC converter 3 in reference to said three-phase DC/AC converter 3. In the case in which the reference point O corresponds with an intermediate point between the positive and the negative of the DC side of the three-phase DC/AC converter 3, the system further comprises a dividing branch (not depicted in the drawings) in said DC side arranged between said positive and said negative, which preferably is a capacitive divider which is preferably formed by two capacitors connected in series, the intermediate point serving as a reference point corresponding with the point of connection P between the two capacitors. The capacitors preferably comprise one and the same capacity.

A second aspect of the invention relates to a verifying method for verifying the status of disconnecting means arranged between a three-phase DC/AC converter 3 and a power grid 4, which is implemented by means of a control unit 8, two disconnecting means 1a, 1b, 1c, 2a, 2b and 2c being connected in series through a midpoint 5, 6 and 7 in each phase L1, L2 and L3. The method aims to verify whether or not the disconnecting means 1a, 1b, 1c, 2a, 2b and 2c work correctly.

In the verifying method, the phase voltage V'_{L1-N}, V'_{L2-N} and V'_{L3-N} between the midpoint 5, 6 and 7 of the three phases L1, L2 and L3 and the neutral N of the power grid 4 is measured, the reference voltage V'_{O-N} between the neutral N of the power grid 4 and the reference point O of the three-phase DC/AC converter 3 is measured, and whether or not the disconnecting means 1a, 1b, 1c, 2a, 2b and 2c work correctly is determined taking into account the measured voltages V'_{L1-N}, V'_{L2-N}, V'_{L3-N} and V'_{O-N}. Therefore, as a result of both the phase voltages V'_{L1-N}, V'_{L2-N} and V'_{L3-N} and of the reference voltage V'_{O-N}, said measured voltages V'_{L1-N}, V'_{L2-N}, V'_{L3-N} and V'_{O-N} can be associated both with the power grid 4 and the three-phase DC/AC converter 3, which allows verifying all the disconnecting means 1a, 1b, 1c, 2a, 2b and 2c with a smaller number of detectors (four) than that used in the state of the art (six), with the advantages that it entails in terms of cost and simplicity in design, for example.

With the method, the status of the external disconnecting means 2a, 2b and 2c is verified taking into account only the phase voltages V'_{L1-N}, V'_{L2-N} and V'_{L3-N}, and the status of the internal disconnecting means 1a, 1b and 1c is verified taking into account the sum of said phase voltages V'_{L1-N}, V'_{L2-N} and V'_{L3-N} and the reference voltage V'_{O-N}, the phase voltages V'_{L1-N}, V'_{L2-N} and V'_{L3-N} on the side of the three-phase DC/AC converter 3 being associated by means of said sums.

In order to determine the status of the disconnecting means 1a, 1b, 1c, 2a, 2b and 2c, a specific opening and closing sequence is applied on the disconnecting means 1a, 1b, 1c, 2a, 2b and 2c, a control over the three-phase DC/AC converter 3 is also performed in which said three-phase DC/AC converter 3 is prevented from generating an alternating voltage during at least one time interval when carrying out the method and in which said three-phase DC/AC converter 3 is allowed to generate a known alternating voltage during at least one time interval when carrying out the method, the measured voltages V'_{L1-N}, V'_{L2-N}, V'_{L3-N} and V'_{O-N}, the specific opening and closing sequence on the disconnecting means 1a, 1b, 1c, 2a, 2b and 2c and the control over the three-phase DC/AC converter 3 being combined in a specific manner.

In a preferred embodiment of the method, the opening and closing sequence of the disconnecting means 1a, 1b, 1c, 2a, 2b and 2c, the measured voltages V'_{L1-N}, V'_{L2-N}, V'_{L3-N} and V'_{O-N} and the control over the three-phase DC/AC converter 3 are linked in the following manner:
The method comprises an external verification step Ee in which the status of the external disconnecting means 2a, 2b, 2c is verified, comprising the following steps:
   - opening, by means of the control unit 8, all the disconnecting means 1a, 1b, 1c, 2a, 2b and 2c (or keeping them open if they are already open);
   - measuring the phase voltages V'_{L1-N}, V'_{L2-N} and V'_{L3-N} with the corresponding detectors 91, 92 and 93;
   - comparing, preferably with the control unit 8, each of said phase voltages V'_{L1-N}, V'_{L2-N} and V'_{L3-N} with a predetermined external threshold value Te; and
   - determining, by means of the control unit 8, the malfunction of one of the external disconnecting means 2a, 2b and 2c if the phase voltage V'_{L1-N}, V'_{L2-N} or V'_{L3-N} associated with its phase L1, L2 or L3 is greater than the predetermined external threshold value Te. If the associated phase voltage V'_{L1-N}, V'_{L2-N} or V'_{L3-N} of a phase L1, L2 or L3 is approximately zero (or below the external threshold value Te), the control unit 8 assumes that there is either no voltage in the power grid 4, or that the operation of said external disconnecting means 2a, 2b and 2c is correct (at least in terms of the opening thereof).

The predetermined external threshold value Te is linked to the rated voltage of the power grid 4, being able to correspond, for example, with 80% of said rated voltage. Below said value, it is considered that there is no power grid 4.

The method further comprises an internal verification step Ei in which the status of the internal disconnecting means 1a, 1b and 1c is verified, comprising the following steps:
- opening, by means of the control unit 8, all the disconnecting means 1a, 1b, 1c, 2a, 2b and 2c (or keeping them open if they are already open);
- generating, by means of an order preferably from the control unit 8, a known alternating voltage by means of the three-phase DC/AC converter 3;
- measuring the phase voltages V'_{L1-N}, V'_{L2-N} and V'_{L3-N} between each phase L1, L2 and L3 and the neutral N of the power grid 4 with the corresponding detectors 91, 92 and 93;
- measuring the reference voltage V'_{O-N} between the neutral N of the power grid 4 and the reference point O of the three-phase DC/AC converter 3 with the corresponding additional detector 90;
- adding, preferably with the control unit 8, the reference voltage V'_{O-N} to each of the phase voltages V'_{L1-N}, V'_{L2-N} and V'_{L3-N}, a voltage phase - reference point O for each phase L1, L2 and L3 thus being obtained;
- comparing, preferably with the control unit 8, the result of each sum with a predetermined internal threshold value Ti, said internal threshold value Ti being equal to or less than the alternating voltage generated by the three-phase DC/AC converter 3; and
- determining, with the control unit 8, the malfunction of one of the internal disconnecting means 1a, 1b and 1c if the result of the sum corresponding to its phase L1, L2 or L3 is greater than the predetermined internal threshold value Ti. If the result of the sum is approximately zero (or less than the internal threshold value Ti), the control unit 8 assumes that either the three-phase DC/AC converter 3 does not work correctly or the operation of the internal disconnecting means 1a, 1b or 1c of the corresponding phase L1, L2 or L3 is correct (at least in terms of the opening thereof).

The predetermined internal threshold value Ti is linked to the alternating voltage generated with the converter, being able to correspond, for example, with 80% of said voltage.

The verification steps Ee and Ei allows determining mainly if the disconnecting means 1a, 1b, 1c, 2a, 2b and 2c work correctly when they are opened, and the method further comprises an additional verification step Ea to determine if said internal disconnecting means 1a, 1b and 1c also work correctly when they are closed. Said additional verification method Ea comprises the following steps:
- closing, by means of the control unit 8, the internal disconnecting means 1a, 1b and 1c (or keeping them closed if they were already closed);
- causing, by means of an order preferably from the control unit 8, the generation a known alternating voltage by means of the three-phase DC/AC converter 3;
- measuring the phase voltages V'_{L1-N}, V'_{L2-N} and V'_{L3-N} between each phase L1, L2 and L3 and the neutral N of the power grid 4 with the corresponding detectors 91, 92 and 93;
- measuring the reference voltage V'_{O-N} between the neutral N of the power grid 4 and the reference point O of the three-phase DC/AC converter 3 with the corresponding additional detector 90;
- adding, preferably with the control unit 8, the reference voltage V'_{O-N} to each of the phase voltages V'_{L1-N}, V'_{L2-N} and V'_{L3-N}, a voltage phase - reference point O for each phase L1, L2 and L3 thus being obtained;
- comparing, preferably with the control unit 8, the result of each sum with a predetermined additional threshold value Ta, said additional threshold value Ta being equal to or less than the alternating voltage generated by the three-phase DC/AC converter 3; and
- determining, with the control unit 8, the malfunction of one of the internal disconnecting means 1a, 1b and 1c if the result of the sum corresponding to its phase L1, L2 or L3 is less than the predetermined additional threshold value Ta. If the result of the sum exceeds the predetermined additional threshold value Ta, the control unit 8 assumes that the three-phase DC/AC converter 3 works correctly and that the operation of the corresponding internal disconnecting means 1a, 1b or 1c is correct.

The additional threshold value Ta preferably corresponds with the internal threshold value Ti.

The method further comprises a final verification step Ef comprising the following steps:
- opening, by means of the control unit 8, the internal disconnecting means 1a, 1b and 1c, while at the same time closing the external disconnecting means 2a, 2b and 2c or keeping them closed;
- measuring the phase voltages V'_{L1-N}, V'_{L2-N} and V'_{L3-N} between each phase L1, L2 and L3 and the neutral N of the power grid 4 with the corresponding detectors 91, 92 and 93;
- comparing each of said phase voltages V'_{L1-N}, V'_{L2-N} and V'_{L3-N} with a predetermined final threshold value Tf; and
- determining that the external disconnecting means 2a, 2b and 2c work correctly if their corresponding measured voltage exceeds the predetermined final threshold value Tf, while at the same time determining that the power grid 4 is connected.

The final threshold value Tf preferably corresponds with the external threshold value Te.

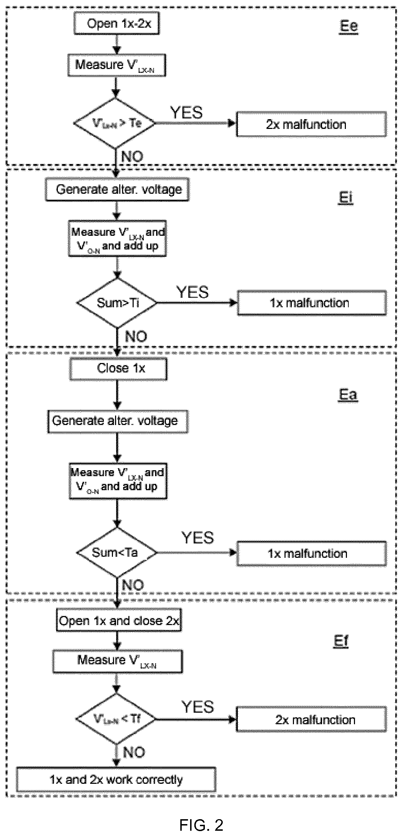

The order for carrying out the steps in the preferred embodiment is as follows: the external verification step Ee is carried out first, followed by the internal verification step Ei, the additional verification step Ea and finally the final verification step Ef; as shown in Figure 2. This order for carrying out the steps is non-limiting, and it may vary in other embodiments.

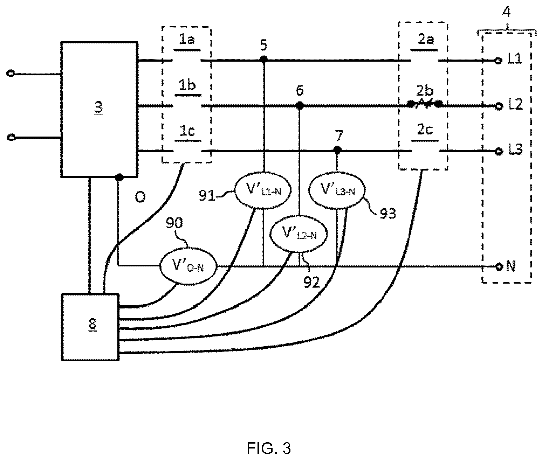

Next and by way of example, the identification of the malfunction of one of the external disconnecting means 2a, 2b and 2c with the method of the invention (particularly with the preferred embodiment of the method) is described, which in this example corresponds with the disconnecting means 2b of the phase L2 as shown in Figure 3, where it is shown that the contacts of said disconnecting means 2b have been short-circuited. As a result, despite the control unit 8 orders said disconnecting means 2b to open, they remain closed at all times.

The external verification step Ee is carried out first. The control unit 8 orders all the disconnecting means 1a, 1b, 1c, 2a, 2b and 2c to open (as described, due to a malfunction, the disconnecting means 2b remain closed, said situation not being yet identified) and the phase voltages V'_{L1-N}, V'_{L2-N} and V'_{L3-N} are detected. Since the external disconnecting means 2b of the phase L2 is closed, the control unit 8 detects that the corresponding phase voltage V'_{L2-N} is above the predetermined external threshold value Te and determines a malfunction of the external disconnecting means associated with said phase (in this case the external disconnecting means 2b associated with the phase L2). The method can continue being implemented for determining whether or not the internal disconnecting means 1a, 1b and 1c and the other external disconnecting means 2a and 2c work correctly.

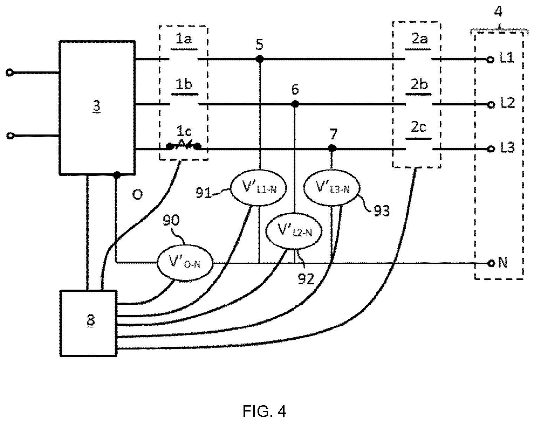

Next and by way of example, the detection of the malfunction of internal disconnecting means 1a, 1b and 1c with the method of the invention (particularly with the preferred embodiment of the method) is described, which in this example correspond with the internal disconnecting means 1c of the phase L3 as shown in Figure 4, where it is shown that the contacts of said internal disconnecting means 1c have been short-circuited. As a result, despite the control unit 8 orders said internal disconnecting means 1c to open, they remain closed.

The external verification step Ee is carried out first. The control unit 8 orders all the disconnecting means 1a, 1b, 1c, 2a, 2b and 2c to open (as described, due to a malfunction, the internal disconnecting means 1c remain closed, said situation not being yet identified) and the phase voltages V'_{L1-N}, V'_{L2-N} and V'_{L3-N} measured by the corresponding detectors 91, 92 and 93 are detected. Since all the external disconnecting means 2a, 2b and 2c were opened (it is assumed that all the external disconnecting means 2a, 2b and 2c work correctly for this example), the control unit 8 detects that the phase voltages V'_{L1-N}, V'_{L2-N} and V'_{L3-N} are equal to approximately zero and do not detect any anomaly therein.

The internal verification step Ei is carried out after the external verification step Ee. The control unit 8 orders the three-phase DC/AC converter 3 to generate a known alternating voltage, the voltages V'_{L1-N}, V'_{L2-N}, V'_{L3-N} and V'_{O-N} are measured, and the reference voltage V'_{O-N} is added to each of the phase voltages V'_{L1-N}, V'_{L2-N} and V'_{L3-N}. Given that the internal disconnecting means 1c of the phase L3 have been short-circuited, the sum of the voltages V'_{L3-N} and V'_{O-N} is above the internal threshold value Ti, and the control unit 8 determines the malfunction of said internal disconnecting means 1c. The method can continue being implemented for determining whether or not the external disconnecting means 2a, 2b and 2c and the other internal disconnecting means 1a and 1c work correctly.

## Claims

1. Verifying system for verifying the disconnecting means of a three-phase DC/AC converter (3), two disconnecting means (1a, 1b, 1c, 2a, 2b, 2c) being connected in series through a midpoint (5, 6, 7) in each phase (L1, L2, L3) between the three-phase DC/AC converter (3) and a power grid (4), the system comprising a plurality of voltage detectors (90, 91, 92, 93) and a control unit (8) which is communicated with said plurality of voltage detectors (90, 91, 92, 93) to receive the measured voltages and which is configured to determine the status of the disconnecting means (1a, 1b, 1c, 2a, 2b, 2c) depending on said voltages, **characterized in that** the plurality of voltage detectors comprises a voltage detector (91, 92, 93) associated with each phase (L1, L2, L3), respectively, for measuring the phase voltages (V'_{L1-N}, V'_{L2-N}, V'_{L3-N}) between each midpoint (5, 6, 7) and the neutral (N) of the power grid (4), and an additional voltage detector (90) for measuring the reference voltage (V'_{O-N}) between the neutral (N) of the power grid (4) and a reference point (O) of the DC side of the three-phase DC/AC converter (3).

2. Verifying system according to claim 1, wherein the control unit (8) is communicated with the disconnecting means (1a, 1b, 1c, 2a, 2b, 2c) and is configured for controlling the opening and closing of said disconnecting means (1a, 1b, 1c, 2a, 2b, 2c), for combining in a specific manner the measured voltages (V'_{L1-N}, V'_{L2-N}, V'_{L3-N}, V'_{O-N}) and the control over the opening and closing of said disconnecting means (1a, 1b, 1c, 2a, 2b, 2c), and for determining the status of the disconnecting means (1a, 1b, 1c, 2a, 2b, 2c) depending on said combination.

3. Verifying system according to any of the preceding claims, wherein the three-phase DC/AC converter (3) comprises a plurality of semiconductor-type switches, the control unit (8) also being suitable for controlling the opening and closing of said switches of the three-phase DC/AC converter (3), the control of said switches being linked to the measured voltages (V'_{L1-N}, V'_{L2-N}, V'_{L3-N}, V'_{O-N}) and to the control over the opening and closing of said disconnecting means (1a, 1b, 1c, 2a, 2b, 2c) in a controlled manner to determine the status of the disconnecting means (1a, 1b, 1c, 2a, 2b, 2c).

4. Verifying system according to any of the preceding claims, wherein the reference point (O) corresponds with the positive of the DC side of the three-phase DC/AC converter (3), with the negative of the DC side of the three-phase DC/AC converter (3) or with an intermediate point between the positive and the negative of the DC side of the three-phase DC/AC converter (3)

5. Verifying system according to any of the preceding claims, wherein the disconnecting means arranged between the midpoints (5, 6, 7) and the three-phase DC/AC converter (3) correspond with internal disconnecting means (1a, 1b, 1c) and are controlled by one and the same signal from the control unit (8) or by three independent signals from the control unit (8).

6. Verifying system according to any of the preceding claims, wherein the disconnecting means arranged between the midpoints (5, 6, 7) and the power grid (4) correspond with external disconnecting means (2a, 2b, 2c) and are controlled by one and the same signal from the control unit (8) or by three independent signals from the control unit (8).

7. Verifying method for verifying the disconnecting means of a three-phase DC/AC converter (3), two disconnecting means (1a, 1b, 1c, 2a, 2b, 2c) being connected in series through a midpoint (5, 6, 7) in each phase (L1, L2, L3) between the three-phase DC/AC converter (3) and a power grid (4), **characterized in that** in the method the phase voltage (V'_{L1-N}, V'_{L2-N}, V'_{L3-N}) between the midpoint (5, 6, 7) of the three phases (L1, L2, L3) and the neutral (N) of the power grid (4) is measured, the reference voltage (V'_{O-N}) between the neutral (N) of the power grid (4) and a reference point (O) of the three-phase DC/AC converter (3) is measured, and the status of the disconnecting means (1a, 1b, 1c, 2a, 2b, 2c) is determined taking into account the measured voltages (V'_{L1-N}, V'_{L2-N}, V'_{L3-N}, V'_{O-N}).

8. Verifying method according to claim 7, wherein the disconnecting means arranged between the midpoints (5, 6, 7) and the three-phase DC/AC converter (3) correspond with internal disconnecting means (1a, 1b, 1c) and wherein the disconnecting means arranged between the midpoints (5, 6, 7) and the power grid (4) correspond with external disconnecting means (2a, 2b, 2c), only the phase voltages (V'_{L1-N}, V'_{L2-N}, V'_{L3-N}) being taken into account to verify the status of the external disconnecting means (2a, 2b, 2c) and the sum of each of said phase voltages (V'_{L1-N}, V'_{L2-N}, V'_{L3-N}) and the reference voltage (V'_{O-N}) being taken into account to verify the status of the internal disconnecting means (1a, 1b, 1c).

9. Verifying method according to claim 8, wherein in order to determine the status of the disconnecting means (1a, 1b, 1c, 2a, 2b, 2c) a specific opening and closing sequence is applied on the disconnecting means (1a, 1b, 1c, 2a, 2b, 2c) and a control over the three-phase DC/AC converter (3) is also performed in which said three-phase DC/AC converter (3) is prevented from generating an alternating voltage during at least one time interval when carrying out the method and in which said three-phase DC/AC converter (3) is allowed to generate a known alternating voltage during at least one time interval when carrying out the method, the measured voltages (V'_{L1-N}, V'_{L2-N}, V'_{L3-N}, V'_{O-N}), the specific opening and closing sequence on the disconnecting means (1a, 1b, 1c, 2a, 2b, 2c) and the control over the three-phase DC/AC converter (3) being combined in a specific manner.

10. Verifying method according to claim 9, comprising an external verification step (Ee) in which all the disconnecting means (1a, 1b, 1c, 2a, 2b, 2c) are open or kept open; the phase voltages (V'_{L1-N}, V'_{L2-N}, V'_{L3-N}) between each midpoint (5, 6, 7) and the neutral (N) of the power grid (4) are measured; each of said phase voltages (V'_{L1-N}, V'_{L2-N}, V'_{L3-N}) is compared with a predetermined external threshold value (Te); and the malfunction of one of the external disconnecting means (2a, 2b, 2c) is determined if the phase voltage (V'_{L1-N}, V'_{L2-N}, V'_{L3-N}) associated with its phase (L1, L2, L3) is greater than the predetermined external threshold value (Te).

11. Verifying method according to claim 9 or 10, comprising an internal verification step (Ei) in which all the disconnecting means (1a, 1b, 1c, 2a, 2b, 2c) are open or kept open; a known alternating voltage is generated by means of the three-phase DC/AC converter (3); the phase voltages (V'_{L1-N}, V'_{L2-N}, V'_{L3-N}) between each midpoint (5, 6, 7) and the neutral (N) of the power grid (4) are measured; the reference voltage (V'_{O-N}) is measured; the reference voltage (V'_{O-N}) is added to each of the phase voltages (V'_{L1-N}, V'_{L2-N}, V'_{L3-N}); the result of each sum is compared with a predetermined internal threshold value (Ti); and the malfunction of one of the internal disconnecting means (1a, 1b, 1c) is determined if the result of the sum corresponding to its phase (L1, L2, L3) is greater than the predetermined internal threshold value (Ti).

12. Verifying method according to any of claims 9 to 11, comprising an additional verification step (Ea) in which all the internal disconnecting means (1a, 1b, 1c) are closed or kept closed; a known alternating voltage is generated by means of the three-phase DC/AC converter (3); the phase voltages (V'_{L1-N}, V'_{L2-N}, V'_{L3-N}) between each midpoint (5, 6, 7) and the neutral (N) of the power grid (4) are measured; the reference voltage (V'_{O-N}) is measured; the reference voltage (V'_{O-N}) is added to each of the measured phase voltages (V'_{L1-N}, V'_{L2-N}, V'_{L3-N}); the result of each sum is compared with a predetermined additional threshold value (Ta); and the malfunction of one of the internal disconnecting means (1a, 1b, 1c) is determined if the result of the sum of its corresponding phase (L1, L2, L3) is less than the predetermined additional threshold value (Ta).

13. Verifying method according to any of claims 9 to 12, comprising a final verification step (Ef) in which the internal disconnecting means (1a, 1b, 1c) are open; the external disconnecting means (2a, 2b, 2c) are closed or kept closed; the phase voltages (V'_{L1-N}, V'_{L2-N}, V'_{L3-N}) between each midpoint (5, 6, 7) and the neutral (N) of the power grid (4) are measured; said phase voltages (V'_{L1-N}, V'_{L2-N}, V'_{L3-N}) are compared with a predetermined final threshold value (Tf); and the malfunction of one of the external disconnecting means (2a, 2b, 2c) is determined if the phase voltage (V'_{L1-N}, V'_{L2-N}, V'_{L3-N}) corresponding to its phase (L1, L2, L3) is less than said final threshold value (Tf).

14. Verifying method according to any of claims 10 to 13, wherein the external verification step (Ee) is carried out first, followed by the internal verification step (Ei), the additional verification step (Ea) and finally the final verification step (Ef).

## Patentansprüche

1. Überprüfungssystem zum Überprüfen der Trennmittel eines dreiphasigen DC/AC-Wandlers (3), wobei zwei Trennmittel (1a, 1b, 1c, 2a, 2b, 2c) durch einen Mittenpunkt (5, 6, 7) in jeder Phase (L1, L2, L3) zwischen dem dreiphasigen DC/AC-Wandler (3) und einem Energieversorgungsnetz (4) in Reihe verbunden sind, wobei das System eine Vielzahl von Spannungsdetektoren (90, 91, 92, 93) und eine Steuereinheit (8) umfasst, mit der Vielzahl von Spannungsmessern (90, 91, 92, 93) in Verbindung steht, um die gemessenen Spannungen zu empfangen, und die so gestaltet ist, dass der Zustand der Trennmittel (1a, 1b, 1c, 2a, 2b, 2c) in Abhängigkeit von den Spannungen ermittelt wird, **dadurch gekennzeichnet, dass** die Vielzahl von Spannungsmessern einen zu jeder Phase (L1, L2, L3) gehörigen Spannungsmesser (91, 92, 93) umfasst, um die Phasenspannungen (V'_{L1-N}, V'_{L2-N}, V'_{L3-N}) zwischen jedem Mittenpunkt (5, 6, 7) und dem Neutralleiter (N) des Energieversorgungsnetzes (4) zu messen, und einen weiteren Spannungsmesser (90) zum Messen der Referenzspannung (V'_{O-N}) zwischen dem Neutralleiter (N) des Energieversorgungsnetzes (4) und einem Referenzpunkt (O) der DC-Seite des dreiphasigen DC/AC-Wandlers (3).

2. Überprüfungssystem nach Anspruch 1, wobei die Steuereinheit (8) mit den Trennmitteln (1a, 1b, 1c, 2a, 2b, 2c) in Verbindung steht und so gestaltet ist, dass das Öffnen und Schließen der Trennmittel (1a, 1b, 1c, 2a, 2b, 2c) gesteuert wird, um die gemessenen Spannungen (V'_{L1-N}, V'_{L2-N}, V'_{L3-N}, V'_{O-N}) und die Kontrolle über das Öffnen und Schließen der Trennmittel (1a, 1b, 1c, 2a, 2b, 2c) in einer bestimmten Weise zu kombinieren und je nach der Kombination den Zustand der Trennmittel (1a, 1b, 1c, 2a, 2b, 2c) zu ermitteln.

3. Überprüfungssystem nach einem der vorhergehenden Ansprüche, wobei der dreiphasige DC/AC-Wandler (3) eine Vielzahl von Halbleiterschaltern umfasst, wobei die Steuereinheit (8) außerdem geeignet ist, um das Öffnen und Schließen der Schalter des dreiphasigen DC/AC-Wandlers (3) zu steuern, wobei die Steuerung der Schalter mit den gemessenen Spannungen (V'_{L1-N}, V'_{L2-N}, V'_{L3-N}, V'_{O-N}) und mit der Kontrolle über das Öffnen und Schließen der Trennmittel (1a, 1b, 1c, 2a, 2b, 2c) in einer kontrollierten Weise verknüpft ist, um den Zustand der Trennmittel (1a, 1b, 1c, 2a, 2b, 2c) zu ermitteln.

4. Überprüfungssystem nach einem der vorhergehenden Ansprüche, wobei der Referenzpunkt (O) mit dem Pluspol der DC-Seite des dreiphasigen DC/AC-Wandlers (3), mit dem Minuspol der DC-Seite des dreiphasigen DC/AC-Wandlers (3) oder mit einem Zwischenpunkt zwischen dem Pluspol und dem Minuspol der DC-Seite des dreiphasigen DC/AC-Wandlers (3) übereinstimmt.

5. Überprüfungssystem nach einem der vorhergehenden Ansprüche, wobei die zwischen den Mittenpunkten (5, 6, 7) und dem dreiphasigen DC/AC-Wandler (3) angeordneten Trennmittel mit internen Trennmitteln (1a, 1b, 1c) übereinstimmen und durch ein und dasselbe Signal von der Steuereinheit (8) oder durch drei unabhängige Signale von der Steuereinheit (8) gesteuert werden.

6. Überprüfungssystem nach einem der vorhergehenden Ansprüche, wobei die zwischen den Mittenpunkten (5, 6, 7) und dem Energieversorgungsnetz (4) angeordneten Trennmittel mit externen Trennmitteln (2a, 2b, 2c) übereinstimmen und durch ein und dasselbe Signal von der Steuereinheit (8) oder durch drei unabhängige Signale von der Steuereinheit (8) gesteuert werden.

7. Überprüfungsverfahren zum Überprüfen der Trennmittel eines dreiphasigen DC/AC-Wandlers (3), wobei zwei Trennmittel (1a, 1b, 1c, 2a, 2b, 2c) durch einen Mittenpunkt (5, 6, 7) in jeder Phase (L1, L2, L3) zwischen dem dreiphasigen DC/AC-Wandler (3) und einem Energieversorgungsnetz (4) in Reihe verbunden sind, **dadurch gekennzeichnet, dass** bei dem Verfahren die Phasenspannung (V'_{L1-N}, V'_{L2-N}, V'_{L3-N}) zwischen dem Mittenpunkt (5, 6, 7) der drei Phasen (L1, L2, L3) und dem Neutralleiter (N) des Energieversorgungsnetzes (4) gemessen wird, die Referenzspannung (V'_{O-N}) zwischen dem Neutralleiter (N) des Energieversorgungsnetzes (4) und einem Referenzpunkt (O) des dreiphasigen DC/AC-Wandlers (3) gemessen wird und der Zustand der Trennmittel (1a, 1b, 1c, 2a, 2b, 2c) unter Berücksichtigung der gemessenen Spannungen (V'_{L1-N}, V'_{L2-N}, V'_{L3-N}, V'_{O-N}) ermittelt wird.

8. Überprüfungsverfahren nach Anspruch 7, wobei die zwischen den Mittenpunkten (5, 6, 7) und dem dreiphasigen DC/AC-Wandler (3) angeordneten Trennmittel mit internen Trennmitteln (1a, 1b, 1c) übereinstimmen und wobei die zwischen den Mittenpunkten (5, 6, 7) und dem Energieversorgungsnetz (4) angeordneten Trennmittel mit externen Trennmitteln (2a, 2b, 2c) übereinstimmen, wobei nur die Phasenspannungen (V'_{L1-N}, V'_{L2-N}, V'_{L3-N}) berücksichtigt werden, um den Zustand der externen Trennmittel (2a, 2b, 2c) zu ermitteln und die Summe jeder der Phasenspannungen (V'_{L1-N}, V'_{L2-N}, V'_{L3-N}) und die Referenzspannung (V'_{O-N}) berücksichtigt werden, um den Zustand der internen Trennmittel (1a, 1b, 1c) zu ermitteln.

9. Überprüfungsverfahren nach Anspruch 8, wobei zur Ermittlung des Zustands der Trennmittel (1a, 1b, 1c, 2a, 2b, 2c) eine bestimmte Reihenfolge des Öffnens und Schließens auf die Trennmittel (1a, 1b, 1c, 2a, 2b, 2c) angewendet wird und außerdem eine Kontrolle über den dreiphasigen DC/AC-Wandler (3) durchgeführt wird, bei der verhindert wird, dass der dreiphasige DC/AC-Wandler (3) während mindestens eines Zeitintervalls bei der Ausführung des Verfahrens eine Wechselspannung erzeugt, und wobei zugelassen wird, dass der dreiphasige DC/AC-Wandler (3) während mindestens eines Zeitintervalls bei der Ausführung des Verfahrens eine bekannte Wechselspannung erzeugt, wobei die gemessenen Spannungen (V'_{L1-N}, V'_{L2-N}, V'_{L3-N}, V'_{O-N}), die betreffende Reihenfolge des Öffnens und Schließens an den Trennmitteln (1a, 1b, 1c, 2a, 2b, 2c) und die Kontrolle über den dreiphasigen DC/AC-Wandler (3) in einer bestimmten Weise kombiniert werden.

10. Überprüfungsverfahren nach Anspruch 9, umfassend einen externen Überprüfungsschritt (Ee), bei dem alle Trennmittel (1a, 1b, 1c, 2a, 2b, 2c) offen sind oder offengehalten werden; die Phasenspannungen (V'_{L1-N}, V'_{L2-N}, V'_{L3-N}) zwischen jedem Mittenpunkt (5, 6, 7) und dem Neutralleiter (N) des Energieversorgungsnetzes (4) gemessen werden; jede der Phasenspannungen (V'_{L1-N}, V'_{L2-N}, V'_{L3-N}) mit einem vorgegebenen externen Schwellenwert (Te) verglichen wird; und die Fehlfunktion eines der externen Trennmittel (2a, 2b, 2c) festgestellt wird, wenn die zu seiner Phase (L1, L2, L3) gehörende Phasenspannung (V'_{L1-N}, V'_{L2-N}, V'_{L3-N}) größer als der vorgegebene externe Schwellenwert (Te) ist.

11. Überprüfungsverfahren nach Anspruch 9 oder 10, umfassend einen internen Überprüfungsschritt (Ei), bei dem alle Trennmittel (1a, 1b, 1c, 2a, 2b, 2c) offen sind oder offengehalten werden; mithilfe des dreiphasigen DC/AC-Wandlers (3) eine bekannte Wechselspannung erzeugt wird; die Phasenspannungen (V'_{L1-N}, V'_{L2-N}, V'_{L3-N}) zwischen jedem Mittenpunkt (5, 6, 7) und dem Neutralleiter (N) des Energieversorgungsnetzes (4) gemessen werden; die Referenzspannung (V'_{O-N}) gemessen wird; die Referenzspannung (V'_{O-N}) zu jeder der Phasenspannungen (V'_{L1-N}, V'_{L2-N}, V'_{L3-N}) addiert wird; das Ergebnis jeder Summe mit einem vorgegebenen internen Schwellenwert (Ti) verglichen wird; und die Fehlfunktion eines der internen Trennmittel (1a, 1b, 1c) festgestellt wird, wenn das Ergebnis der seiner Phase (L1, L2, L3) entsprechenden Summe größer als der vorgegebene interne Schwellenwert (Ti) ist.

12. Überprüfungsverfahren nach einem der Ansprüche 9 bis 11, umfassend einen weiteren Überprüfungsschritt (Ea), bei dem alle internen Trennmittel (1a, 1b, 1c) geschlossen sind oder geschlossen gehalten werden; mithilfe des dreiphasigen DC/AC-Wandlers (3) eine bekannte Wechselspannung erzeugt wird; die Phasenspannungen (V'_{L1-N}, V'_{L2-N}, V'_{L3-N}) zwischen Mittenpunkt (5, 6, 7) und dem Neutralleiter (N) des Energieversorgungsnetzes (4) gemessen werden; die Referenzspannung (V'_{O-N}) gemessen wird; die Referenzspannung (V'_{O-N}) zu jeder der gemessenen Phasenspannungen (V'_{L1-N}, V'_{L2-N}, V'_{L3-N}) addiert wird; das Ergebnis jeder Summe mit einem vorgegebenen weiteren Schwellenwert (Ta) verglichen wird; und die Fehlfunktion eines der internen Trennmittel (1a, 1b, 1c) festgestellt wird, wenn das Ergebnis der seiner Phase (L1, L2, L3) entsprechenden Summe kleiner als der vorgegebene weitere Schwellenwert (Ta) ist.

13. Überprüfungsverfahren nach einem der Ansprüche 9 bis 12, umfassend einen abschließenden Überprüfungsschritt (Ef), bei dem die internen Trennmittel (1a, 1b, 1c) offen sind; die externen Trennmittel (2a, 2b, 2c) geflossen sind oder geschlossen gehalten werden; die Phasenspannungen (V'_{L1-N}, V'_{L2-N}, V'_{L3-N}) zwischen jedem Mittenpunkt (5, 6, 7) und dem Neutralleiter (N) des Energieversorgungsnetzes (4) gemessen werden; die Phasenspannungen (V'_{L1-N}, V'_{L2-N}, V'_{L3-N}) mit einem vorgegebenen abschließenden Schwellenwert (Tf) verglichen werden; und die Fehlfunktion eines der externen Trennmittel (2a, 2b, 2c) festgestellt wird, wenn die seiner Phase (L1, L2, L3) entsprechende Phasenspannung (V'_{L1-N}, V'_{L2-N}, V'_{L3-N}) kleiner als der abschließende Schwellenwert (Tf) ist.

14. Überprüfungsverfahren nach einem der Ansprüche 10 bis 13, wobei der externe Überprüfungsschritt (Ee) zuerst durchgeführt wird, gefolgt vom internen Überprüfungsschritt (Ei), vom weiteren Überprüfungsschritt (Ea) und schließlich vom abschließenden Überprüfungsschritt (Ef).

## Revendications

1. Système de vérification destiné à vérifier les moyens de déconnexion d'un onduleur CC/CA triphasé (3), deux moyens de déconnexion (1a, 1b, 1c, 2a, 2b, 2c) étant connectés en série par un point médian (5, 6, 7) dans chaque phase (L1, L2, L3) entre l'onduleur CC/CA triphasé (3) et un réseau électrique (4), le système comprenant une pluralité de détecteurs de tension (90, 91, 92, 93) et une unité de commande (8) qui est en communication avec ladite pluralité de détecteurs de tension (90,91, 92, 93) pour recevoir les tensions mesurées et qui est conçue pour déterminer l'état des moyens de déconnexion (1a, 1b, 1c, 2a, 2b, 2c) en fonction desdites tensions, **caractérisé en ce que** la pluralité de détecteurs de tension comprend un détecteur de tension (91, 92, 93) associé à chaque phase (L1, L2, L3), respectivement, destiné à mesurer les tensions de phase (V'_{L1-N}, V'_{L2-N}, V'_{L3-N}) entre chaque point médian (5, 6, 7) et le neutre (N) du réseau électrique (4), et un détecteur de tension supplémentaire (90) destiné à mesurer la tension de référence (V'_{O-N}) entre le neutre (N) du réseau électrique (4) et un point de référence (O) du côté CC de l'onduleur CC/CA triphasé (3).

2. Système de vérification selon la revendication 1, l'unité de commande (8) est en communication avec les moyens de déconnexion (1a, 1b, 1c, 2a, 2b, 2c) et est conçue pour régler l'ouverture et la fermeture desdits moyens de déconnexion (1a, 1b, 1c, 2a, 2b, 2c), pour combiner d'une manière spécifique les tensions mesurées (V'_{L1-N}, V'_{L2-N}, V'_{L3-N}, V'_{O-N}) et le réglage de l'ouverture et de la fermeture desdits moyens de déconnexion (1a, 1b, 1c, 2a, 2b, 2c), et pour déterminer l'état des moyens de déconnexion (1a, 1b, 1c, 2a, 2b, 2c) en fonction de ladite combinaison.

3. Système de vérification selon l'une quelconque des revendications précédentes, l'onduleur CC/CA triphasé (3) comprenant une pluralité d'interrupteurs de type à semiconducteur, l'unité de commande (8) étant également appropriée pour régler l'ouverture et la fermeture desdits interrupteurs de l'onduleur CC/CA triphasé (3), la commande desdits interrupteurs étant liée aux tensions mesurées (V'_{L1-N}, V'_{L2-N}, V'_{L3-N}, V'_{O-N}) et à le réglage de l'ouverture et de la fermeture desdits moyens de déconnexion (1a, 1b, 1c, 2a, 2b, 2c) de façon commandée pour déterminer l'état des moyens de déconnexion (1a, 1b, 1c, 2a, 2b, 2c).

4. Système de vérification selon l'une quelconque des revendications précédentes, le point de référence (O) correspondant au positif du côté CC de l'onduleur CC/CA triphasé (3), au négatif du côté CC de l'onduleur CC/CA triphasé (3) ou au point intermédiaire entre le positif et le négatif du côté CC de l'onduleur CC/CA triphasé (3).

5. Système de vérification selon l'une quelconque des revendications précédentes, les moyens de déconnexion disposés entre les points médians (5, 6, 7) et l'onduleur CC/CA triphasé (3) correspondant aux moyens de déconnexion internes (1a, 1b, 1c) et étant commandés par un seul et même signal provenant de l'unité de commande (8) ou par trois signaux indépendants provenant de l'unité de commande (8).

6. Système de vérification selon l'une quelconque des revendications précédentes, les moyens de déconnexion disposés entre les points médians (5, 6, 7) et le réseau électrique (4) correspondant aux moyens de déconnexion externes (2a, 2b, 2c) et étant commandés par un seul et même signal provenant de l'unité de commande (8) ou par trois signaux indépendants provenant de l'unité de commande (8).

7. Procédé de vérification destiné à vérifier les moyens de déconnexion de l'onduleur CC/CA triphasé (3), deux moyens de déconnexion (1a, 1b, 1c, 2a, 2b, 2c) étant connectés en série par un point médian (5, 6, 7) dans chaque phase (L1, L2, L3) entre l'onduleur CC/CA triphasé (3) et un réseau électrique (4), **caractérisé en ce que** selon le procédé, la tension entre phases (V'_{L1-N}, V'_{L2-N}, V'_{L3-N}) entre le point médian (5, 6, 7) des trois phases (L1, L2, L3) et le neutre (N) du réseau électrique (4) est mesurée, la tension de référence (V'_{O-N}) entre le neutre (N) du réseau électrique (4) et un point de référence (O) de l'onduleur CC/CA triphasé (3) est mesuré, et l'état des moyens de déconnexion (1a, 1b, 1c, 2a, 2b, 2c) est déterminé en tenant compte des tensions mesurées (V'_{L1-N}, V'_{L2-N}, V'_{L3-N}, V'_{O-N}).

8. Procédé de vérification selon la revendication 7, les moyens de déconnexion disposés entre les points médians (5, 6, 7) et l'onduleur CC/CA triphasé (3) correspondant aux moyens de déconnexion internes (1a, 1b, 1c) et les moyens de déconnexion disposés entre les points médians (5, 6, 7) et le réseau électrique (4) correspondant aux moyens de déconnexion externes (2a, 2b, 2c), seules les tensions entre phases (V'_{L1-N}, V'_{L2-N}, V'_{L3-N}) étant prises en compte pour vérifier l'état des moyens de déconnexion externes (2a, 2b, 2c) et la somme de chacune desdites tensions entre phases (V'_{L1-N}, V'_{L2-N}, V'_{L3-N}) et de la tension de référence (V'_{O-N}) état prises en compte pour vérifier l'état des moyens de déconnexion internes (1a, 1b, 1c).

9. Procédé de vérification selon la revendication 8, afin de déterminer l'état des moyens de déconnexion (1a, 1b, 1c, 2a, 2b, 2c) une séquence d'ouverture et de fermeture spécifique étant appliquée aux moyens de déconnexion (1a, 1b, 1c, 2a, 2b, 2c) et un réglage de l'onduleur CC/CA triphasé (3) étant également effectué, l'onduleur CC/CA triphasé (3) étant empêché de produire une tension alternative pendant au moins un intervalle de temps lors de l'exécution du procédé et durant lequel ledit onduleur CC/CA triphasé (3) est autorisé à produire une tension alternative connue pendant au moins un intervalle de temps lors de l'exécution du procédé, les tensions mesurées (V'_{L1-N}, V'_{L2-N}, V'_{L3-N}, V'_{O-N}), la séquence spécifique d'ouverture et de fermeture sur les moyens de déconnexion (1a, 1b, 1c, 2a, 2b, 2c) et le réglage de l'onduleur CC/CA triphasé (3) étant combinés d'une manière spécifique.

10. Procédé de vérification selon la revendication 9, comprenant une étape de vérification externe (Ee) dans laquelle tous les moyens de déconnexion (1a, 1b, 1c, 2a, 2b, 2c) sont ouverts ou gardés ouverts ; les tensions entre phases (V'_{L1-N}, V'_{L2-N}, V'_{L3-N}) entre chaque point médian (5, 6, 7) et le neutre (N) du réseau électrique (4) sont mesurées ; chacune desdites tensions entre phases (V'_{L1-N}, V'_{L2-N}, V'_{L3-N}) étant comparée à une valeur de seuil externe prédéfinie (Te) ; et le dysfonctionnement de l'un des moyens de déconnexion externes (2a, 2b, 2c) est déterminé si la tension entre phases (V'_{L1-N}, V'_{L2-N}, V'_{L3-N}) associée à sa phase (L1, L2, L3) est supérieure à la valeur de seuil externe prédéfinie (Te).

11. Procédé de vérification selon la revendication 9 ou 10, comprenant une étape de vérification interne (Ei) dans laquelle les moyens de déconnexion (1a, 1b, 1c, 2a, 2b, 2c) sont ouverts ou gardés ouverts ; une tension alternative connue étant produite au moyen de l'onduleur CC/CA triphasé (3) ; les tensions entre phases (V'_{L1-N}, V'_{L2-N}, V'_{L3-N}) entre chaque point médian (5, 6, 7) et le neutre (N) du réseau électrique (4) sont mesurées ; la tension de référence (V'_{O-N}) est mesurée ; la tension de référence (V'_{O-N}) est ajoutée à chacune des tensions entre phases (V'_{L1-N}, V'_{L2-N}, V'_{L3-N}) ; le résultat de chaque somme est comparé à la valeur de seuil interne prédéfinie (Ti) ; et le dysfonctionnement d'un des moyens de déconnexion internes (1a, 1b, 1c) est déterminé si le résultat de la somme correspondant à sa phase (L1, L2, L3) est supérieure à la valeur de seuil interne prédéfinie (Ti).

12. Procédé de vérification selon l'une quelconque des revendications 9 à 11, comprenant une étape de vérification interne (Ea) dans laquelle les moyens de déconnexion internes (1a, 1b, 1c) sont fermés ou gardés fermés ; une tension alternative connue étant produite au moyen de l'onduleur CC/CA triphasé (3) ; les tensions entre phases (V'_{L1-N}, V'_{L2-N}, V'_{L3-N}) entre chaque point médian (5, 6, 7) et le neutre (N) du réseau électrique (4) sont mesurées ; la tension de référence (V'_{O-N}) est mesurée ; la tension de référence (V'_{O-N}) est ajoutée à chacune des tensions de phase mesurées (V'_{L1-N}, V'_{L2-N}, V'_{L3-N}) ; le résultat de chaque somme est comparé à une valeur de seuil interne prédéfinie (Ta) ; et le dysfonctionnement d'un des moyens de déconnexion internes (1a, 1b, 1c) est déterminé si le résultat de la somme correspondant à sa phase (L1, L2, L3) est inférieure à la valeur de seuil interne supplémentaire prédéfinie (Ta).

13. Procédé de vérification selon l'une quelconque des revendications 9 à 12, comprenant une étape de vérification finale (Ef) dans laquelle tous les moyens de déconnexion internes (1a, 1b, 1c) sont ouverts ; les moyens de déconnexion externes (2a, 2b, 2c) sont fermés ou gardés fermés ; les tensions entre phases (V'_{L1-N}, V'_{L2-N}, V'_{L3-N}) entre chaque point médian (5, 6, 7) et le neutre (N) du réseau électrique (4) sont mesurées ; lesdites tensions entre phases (V'_{L1-N}, V'_{L2-N}, V'_{L3-N}) étant comparées à une valeur de seuil finale prédéfinie (Tf) ; et le dysfonctionnement de l'un des moyens de déconnexion externes (2a, 2b, 2c) est déterminé si la tension de phase (V'_{L1-N}, V'_{L2-N}, V'_{L3-N}) associée à sa phase (L1, L2, L3) est inférieure à ladite valeur de seuil finale prédéfinie (Tf).

14. Procédé de vérification selon l'une quelconque des revendications 10 à 13, l'étape de vérification externe (Ee) est d'abord réalisée, suivie par l'étape de vérification interne (Ei), l'étape de vérification supplémentaire (Ea) et enfin l'étape de vérification finale (Ef).
